# EUROPEAN PATENT SPECIFICATION

(11) **EP 4 330 780 B1**
(45) Date of publication and mention of the grant of the patent: **03.06.2026**
(21) Application number: 22722887.1
(22) Date of filing: 12.04.2022
(51) Int. Cl.: G05B 23/02

(54) **METHOD AND SYSTEM FOR PREDICTIVE MAINTENANCE OF SAMPLE HANDLING SYSTEM (SHS) OF A GAS ANALYZER**
VERFAHREN UND SYSTEM ZUR PRÄDIKTIVEN WARTUNG EINES PROBENHANDHABUNGSSYSTEMS (SHS) EINES GASANALYSATORS
PROCÉDÉ ET SYSTÈME DE MAINTENANCE PRÉDICTIVE D'UN SYSTÈME DE MANIPULATION D'ÉCHANTILLONS (SHS) D'UN ANALYSEUR DE GAZ

(30) Priority: 30.04.2021 IN 202141019858
(43) Date of publication of application: 06.03.2024
(73) Proprietor: ABB SCHWEIZ AG, 5400 Baden (CH)
(72) Inventor: ABHILASH, Pani, Bangalore, Karnataka 560037 (IN); MEKAPATI, Srinivas, Guntur, Andhra Pradesh, 522002 (IN); JINENDRA, Gugaliya, Bangalore 560048 (IN)
(74) Representative: Zimmermann & Partner Patentanwälte mbB
(86) International application number: PCT/IB2022/053401
(87) International publication number: WO 2022/229766

(56) References cited:
- WO-A1-2020/053807
- JEROME WORKMAN ET AL: "Process Analytical Chemistry", ANALYTICAL CHEMISTRY, AMERICAN CHEMICAL SOCIETY, US, vol. 71, no. 12, 15 June 1999 (1999-06-15), pages 121R - 180R, XP008130956, ISSN: 0003-2700, DOI: 10.1021/A1990007S

## Description

### Technical Field

The present invention relates in general to Sample Handling System (SHS) of a gas analyzer. More specifically, the present invention relates to a method and system for performing predictive maintenance of the SHS.

### Background

Gas Analyzers (GAs) are used across industries for monitoring real-time pollutant content in flue gasses. As the governments across the globe have become more vigilant and stringent on emission norms, reliability and availability of these GAs have become very crucial. Reliability of the GAs are dependent not only on the GA devices, but also on associated Sample Handling Systems (SHSs). It is discovered that the majority of failures in the GAs are due to issues in the associated SHSs.

Consequently, one of the ways to enhance reliability of the GAs was to eliminate failures in the SHSs. Therefore, sensor-based Condition Monitoring (CM) systems for SHS were developed. Such CM solutions provided access to various crucial parameters of the SHS, which along with CM logics, were used to trigger- alarms for abnormal operation of the SHS. These alarms help the service team to identify and fix the issues earlier. However, these solutions are reactive in nature. As a result, the existing CM solutions face lot of challenges.

One of the major challenges in the existing CM solutions is high capital cost. In the existing CM solutions, once an alarm triggers, service team will have very little or no time to plan for a maintenance, leading to substantial downtimes. Therefore, in many installations, backup components are provided, such that the service team can plan for the maintenance, and thereby reduce the unplanned downtime of the SHS. However, having backup components adds up to the capital cost of the SHS. Secondly, the existing CM solutions implement the CM logics considering equipment in isolation and hence, component interaction is not considered in the CM logic. This results in false positive alarms being raised. The 'false positive' is a condition when an alarm gets triggered without any problem in the equipment. This happens as the monitored signals for each component are affected due to interaction between the components in the SHS. These false positives can even lead to misleading root causes for a given fault. The false positives may also occur due to unavailability of upstream and downstream data. This adversely impacts the accuracy and reliability of the CM solutions. Also, most of the existing CMs are domain-based and utilize fixed set of rules to identify issues and trigger alarms accordingly. Therefore, such CMs fail to detect an unseen fault.

WO 2020/053807 A1 describes a technique for monitoring condition of a sample handling system of a gas analyzer. Workman et al. describe a sampling system which relies on local indicators in Jerome Workman et al.: "Process Analytical Chemistry", Analytical Chemistry, American Chemical Society, US, vol. 71, no. 12, 15 June 1999, pages 121R-180R.

Hence, there is a need for a system that accurately predicts component failures before they occur, without giving any false alarms.

### Summary of the Invention

It is an objective of the present invention to mitigate, alleviate or eliminate one or more of the above-identified deficiencies and disadvantages in the existing solutions and solve at least the above-mentioned problems.

In view of the foregoing, an embodiment of the present invention relates to a method and a predictive maintenance system for performing a predictive maintenance of a Sample Handling System (SHS) of a Gas Analyzer. The invention is set out in the appended set of claims. In an embodiment, the predictive maintenance system is operationally coupled with the SHS. The SHS comprises a plurality of components and is associated with at least one database, which is configured to store at least one of real-time operational data and historical operational data related to the SHS and each of the plurality components in the SHS. In an embodiment, the predictive maintenance system determines an optimal operational range for the SHS and for each of the plurality of components, by analyzing the real-time operational data and the historical operational data using a pretrained prediction model. In an embodiment, the pretrained prediction model comprises a primary prediction module and a plurality of secondary prediction modules. Further, the predictive maintenance system detects a system fault in the SHS by comparing the real-time operational data of the SHS with the optimal operational range of the SHS using the primary prediction module. Furthermore, the predictive maintenance system detects a component fault in at least one of the plurality of components by comparing the real-time operational data of each of the plurality of components with the optimal operational range of each of the plurality of components using the plurality of secondary prediction modules. Thereafter, the predictive maintenance system forecasts a future operational state of each of the plurality of components based on information related to the system fault detected in the SHS, information related to the component fault detected in at least one of the plurality of components and topology information related to the plurality of components, thereby predicting the possible faults in the SHS and/or the plurality of components in the SHS.

In an embodiment, the plurality of components of the SHS may include, without limiting to, a sample probe, a ring heater, a heat tracer line, a bypass valve, a filter, a gas cooler and a pump.

In an embodiment, the predictive maintenance system determines the optimal operational range for the SHS and each of the plurality of components by analysing, with the pretrained prediction model, one or more domain specific logics and time series data related to one or more upstream processes and one or more downstream processes associated with the SHS.

In an embodiment, the predictive maintenance system detects the component fault in at least one of the plurality of components by performing the following steps. Initially, the predictive maintenance system estimates a maximum number of degradation states for each of the plurality of components by analysing failure data associated with each of the plurality of components using the plurality of secondary prediction modules. Further, the predictive maintenance system detects, using the plurality of secondary prediction modules, a current degradation state of each of the plurality of components by correlating the maximum number of degradation states of each of the plurality of components with the real-time operational data associated with each of the plurality of components.

In an embodiment, the predictive maintenance system displays information related to the future operational state on a user interface associated with the predictive maintenance system after forecasting the future operational state of each of the plurality of components.

In an embodiment, the predictive maintenance system is further configured to compare the future operational state of each of the plurality of components with a threshold operational range and identify a fault in the future operational state of the plurality of components based on comparison. Further, the predictive maintenance system generates one or more alerts upon identifying the fault in the future operational state.

In an embodiment, the predictive maintenance system generates a fault propagation path, corresponding to the fault in the future operational state, using the topology information related to the plurality of components.

In an embodiment, the predictive maintenance system is optionally configured on at least one of an edge device or a cloud platform for remotely performing the predictive maintenance of the SHS.

Systems of varying scope are described herein. In addition to the aspects and advantages described in this summary, further aspects and advantages will become apparent by reference to the drawings and with reference to the detailed description that follows.

### Brief Description of the Drawings

The subject matter of the invention will be explained in more detail in the following text with reference to preferred exemplary embodiments which are illustrated in the drawings, in which:
Figure. 1 illustrates a process flow in a Sample Handling System (SHS), in accordance with some embodiments of the present invention;
Figure. 2a illustrates using a predictive maintenance system for performing predictive maintenance of the SHS, in accordance with some embodiments of the present invention;
Figure. 2b illustrates an internal architecture of the predictive maintenance system configured for performing predictive maintenance of the SHS, in accordance with some embodiments of the present invention;
Figure. 3a illustrates a training phase of a prediction model for determining optimal operational range for the SHS, in accordance with some embodiments of the present invention;
Figure. 3b illustrates an exemplary flowchart of real-time monitoring of the SHS, in accordance with some embodiments of the present invention;
Figure. 4a illustrates an exemplary User Interface (UI) showing various information predicted and displayed by the predictive maintenance system, in accordance with some embodiments of the present invention;
Figures. 4b and 4c show exemplary plots of forecasted state information, in accordance with some embodiments of the present invention; and
Figure. 5 illustrates a method of performing predictive maintenance of the SHS, in accordance with some embodiments of the present invention.

The present disclosure will become apparent from the detailed description given below. The disclosure of the embodiments and other objects and advantages of the present invention herein will be better appreciated and understood when considered in conjunction with the following description and the accompanying drawings. The accompanying drawings are incorporated for illustration of preferred embodiments of the present invention and are not intended to limit the scope thereof. It should be understood, however, that the following descriptions, while indicating preferred embodiments and numerous specific details thereof, are given by way of illustration and not of limitation.

### Detailed Description:

Embodiments of the present invention relates to performing a predictive maintenance of a Sample Handling System (SHS) of a Gas Analyzer. In an embodiment, a predictive maintenance system of present invention determines an optimal operational range for the SHS and for each of the plurality of components using a pretrained prediction model comprising a primary prediction module and a plurality of secondary prediction modules. Further, the predictive maintenance system detects a system fault in the SHS and a component fault in at least one of the plurality of components by comparing the real-time operational data with the optimal operational range of the SHS and the plurality of components, respectively. Thereafter, the predictive maintenance system forecasts a future operational state of each of the plurality of components based on information related to the system fault detected in the SHS, the fault detected in at least one of the plurality of components and topology information related to the plurality of components, for performing the predictive maintenance of the SHS.

In an embodiment, the proposed invention helps in forecasting failure of components of the SHS and thereby provides enough time for the service team to plan for maintenance activity. Consequently, the present invention minimizes downtime of the SHS by reducing unplanned maintenance. Further, by forecasting the failures before even they actually occur, the present invention eliminates the need for using back-up components and thus, reduces capital cost. Moreover, the present invention improves accuracy of forecasting and/or failure prediction by using data from sensor networks, data from upstream and downstream processes along with gas analyzer data. The forecasting accuracy is further improved by considering dependency or interaction between various components in the SHS. In addition, the present invention makes it possible to generate fault propagation paths to help the service team identify a root cause quickly, and also helping them in detecting unseen faults/abnormal conditions.

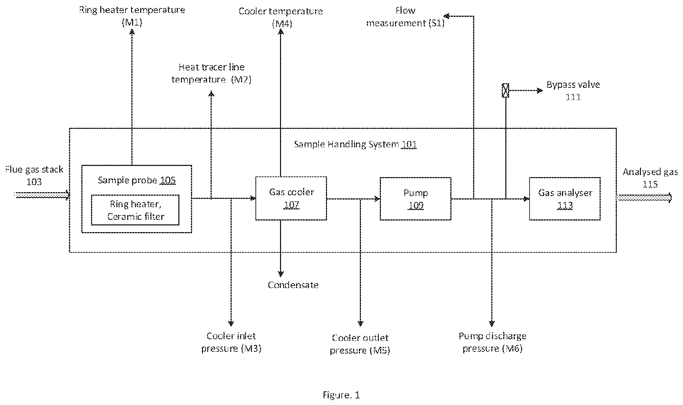

Figure. 1 illustrates a process flow of a Sample Handling System, SHS, (101). As shown in Figure. 1, the SHS (101) may include a plurality of components, each of which are communicatively and operatively configured to purify a gas mixture comprising a flue gas, before the gas mixture is analyzed at a gas analyzer (113). In an embodiment, without limitation, the SHS (101) may be implemented in power plants, refineries, petrochemical, chemical plants, and the like. Also, the SHS (101) may be used for various applications including, without limitation, isolation, filtration, and control of pressure, temperature or flow of plurality of gas analyzers (113) deployed at an industrial plant. While there may be different types and designs of commercially available SHS (101), the function of all types of SHS (101) remains the same, which is to condition the gas mixture to remove dust, moisture and corrosive substances from the gas mixture.

In an embodiment, the SHS (101) may obtain the gas mixture from a flue gas stack (103). The gas mixture may refer to the gas being released into the atmosphere via a flue, which is a pipe or a channel used for conveying exhaust gases from the industrial plants to external atmosphere. In an embodiment, after obtaining the gas mixture from the flue gas stack (103), the gas mixture may be processed and/or conditioned by a plurality of components of the SHS (101). In an exemplary implementation, the plurality of components in the SHS (101) may include, without limitation, a sample probe (105) comprising a ring heater and a ceramic filter, a gas cooler (107), a pump (109), a bypass valve (111) and a gas analyzer (113).

In an embodiment, the sample probe (105) receives the gas mixture from the flue gas stack (103) and heats the gas mixture to a temperature 'M1' using the ring heater in the sample probe (105). Further, a heat tracer line (not shown in Figure. 1) associated with the ring heater may be used for maintaining the temperature of the gas mixture at a desired temperature 'M2', which is also referred as the heat tracer line temperature 'M2'. In other words, the sample probe (105) ensures that the gas mixture is maintained at the desired temperature level until the sample reaches the gas cooler (107). Maintaining the temperature of the gas mixture in the desired temperature level is necessary to avoid condensation of moisture in the pipeline, which otherwise creates several operational problems in the SHS (101). In an embodiment, the ceramic filter in the sample probe (105) may be used for filtering the gas mixture to remove any dust or colloidal particles.

In an embodiment, once the heated gas mixture reaches the gas cooler (107), the gas cooler (107) may cool the gas mixture for removing the heat from the gas mixture, using a coolant. The removal of heat from the gas mixture results in condensation of the moisture and the same may be removed as a condensate from the gas cooler (107). The coolant may cool the gas mixture to a temperature 'M4'. Here, the heated gas mixture from the sample probe (105) may reach the gas cooler (107) with a pressure 'M3' (also referred as cooler inlet pressure 'M3') and the dry gas mixture from the gas cooler (107) may be passed to the pump (109) with a cooler outlet pressure 'M5'.

In an embodiment, the dry gas mixture from the gas cooler (107) may be pumped to the gas analyzer (113) via the pump (109). Here, the pump (109) may elevate the pressure of the dry gas mixture to a pump discharge pressure 'M6'. In an embodiment, a soft sensor (not shown in Figure. 1) configured in the SHS (101) may make an overall flow measurement 'S1' of the dry gas mixture based on the cooler outlet pressure 'M5' and the pump discharge pressure 'M6'. Finally, the dry gas mixture may be passed to the gas analyzer (113) for further analysis. A bypass valve (111) may be used to control the flow of dry gas from the pump (109) to the gas analyzer (113) by bypassing some amount of flow from the pump (109).

In an embodiment, the gas analyzer (113) may analyze various gases in the dry gas mixture, which is being released into the atmosphere as an analyzed gas (115) output. As an example, the analyzed gas (115) may include, without limitation, Nitrogen (N₂), Carbon Dioxide (CO₂), Oxygen (O₂) and the like. Additionally, the dry gas mixture may also include water vapors, as well as a small percentage of pollutants, Carbon monoxide (CO), Nitrogen oxides (i.e., NO, NO₂, etc.,), Sulfur oxides (SO, SO₂ etc.,) and the like.

In an embodiment, the SHS (101) may be configured to perform real-time measurements of each of the parameters M1-M6 and S1, which are related to the gas mixture being processed at various processing stages of the SHS (101) and generate the real-time operational data for the SHS (101) and the plurality of components in the SHS (101). As an example, the cooler temperature 'M4' and the cooler outlet pressure 'M5', that are measured at an inlet and an outlet of the gas cooler (107) respectively, may be considered as the real-time operational data associated with the gas cooler (107). Similarly, a collection of the real-time data from each of the plurality of components in the SHS (101) may be considered as the real-time operational data of the SHS (101). In an embodiment, some or all of these real-time operational data may be used in the predictive maintenance of the SHS (101) and/or the plurality of components in the SHS (101).

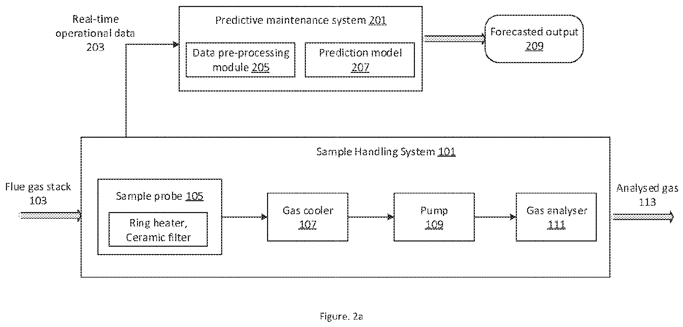

Reference is now made to Figure. 2a. Figure 2a illustrates using a predictive maintenance system (201) for performing predictive maintenance of the SHS (101). In an embodiment, the predictive maintenance system (201) may be any computing device that is configured for performing the predictive maintenance of the SHS (101), according to embodiments of the present invention. As an example, the predictive maintenance system (201) may include, without limiting to, a smartphone, a laptop, a desktop computer, a server, a cloud computing device or any other type of edge device. In an embodiment, the predictive maintenance system (201) may be deployed external to the SHS (101) and operationally coupled with the SHS (101). Alternatively, in an embodiment, the predictive maintenance system (201) may be configured as a part of the SHS (101), within the SHS (101).

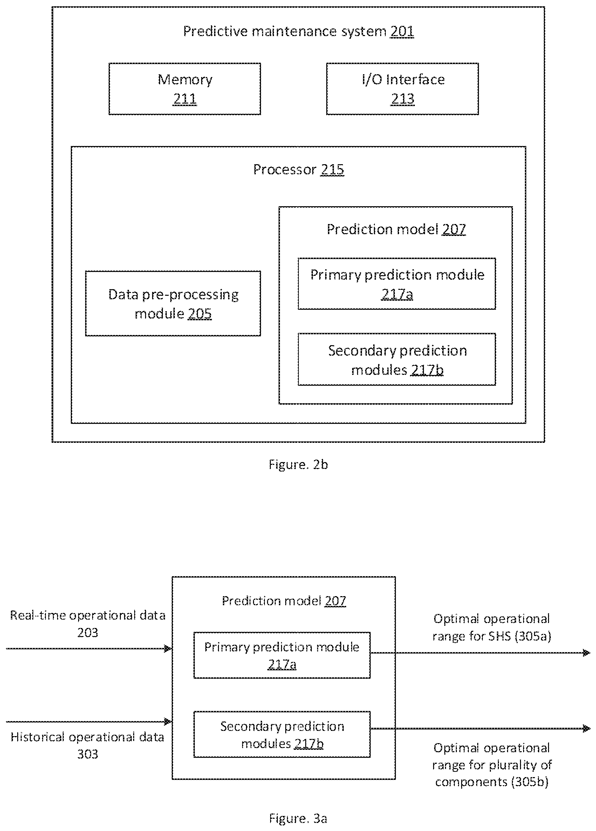

As shown in Figure. 2a, the predictive maintenance system (201) may receive real-time operational data (203) related to the SHS (101) and the plurality of components in the SHS (101), for performing the predictive maintenance of the SHS (101) and/or the plurality of components in the SHS (101). As an example, the real-time operational data (203) may include, without limitation, values of the parameter M1-M6 and S1 (illustrated in Figure. 1), which are measured in real-time. In an embodiment, after receiving the real-time operational data (203) from the SHS (101), a data pre-processing module (205) in the predictive maintenance system (201) may pre-process the real-time operational data (203) according to a desired predefined set of rules. The functions of the data pre-processing module (205) are further illustrated in detail with reference to Figure. 2b.

After pre-processing the real-time operational data (203), a prediction model (207) in the predictive maintenance system (201) may analyze the real-time operational data (203) for predicting and/or forecasting one or more faults in the SHS (101) and/or in at least one of the plurality of components in the SHS (101). In an embodiment, the prediction model (207) may operate in two stages, that is, the training stage and the real-time monitoring stage. In the training stage, the prediction model (207) may analyze a combination of the real-time operational data (203), historical operational data for building a plurality of prediction modules required for forecasting the faults in the SHS (101). Further, in the real-time monitoring stage, the trained prediction modules monitor the real-time operational data (203) for detecting current faults in the SHS (101) and at least one of the plurality of components. Thereafter, based on information related to the detected faults and topology information associated with the plurality of components, the trained prediction modules may predict and/or forecast future faults in the SHS (101) or the plurality of components. That is, the forecasted output (209) generated by the prediction model (207) may be used for predicting the future faults in the SHS (101) and/or the plurality of components, and thereby, the maintenance of the SHS (101) and/or the plurality of components may be predicted and appropriately planned.

Figure. 2b illustrates an internal architecture of the predictive maintenance system (201). In an embodiment, the predictive maintenance system (201) may comprise a memory (211), an Input/ Output (I/O) interface (213) and one or more processors (collectively represented by a processor 215). In an embodiment, the memory (211) may be a storage unit, or a database used for storing the real-time operational data (203), historical operational data, and other data and information related to the SHS (101) and the plurality of components in the SHS (101). In an embodiment, the I/O Interface (213) may be configured for provisioning connection and communication between the predictive maintenance system (201), the SHS (101) and the plurality of components in the SHS (101) using predefined communication interfaces. As an example, the predefined communication interfaces may include, without limiting to, wireless communication networks and wired communication networks.

In an embodiment, the processor (215) may comprise, without limiting to, a data pre-processing module (205) and a prediction model (207). The processor (215) may receive the real-time operational data (203) from the SHS (101), through the I/O Interface (213). As an example, the real-time operational data (203) may be time series values of the parameters M1-M6 and S1 collected in real-time from the SHS (101) and the plurality of components in the SHS (101).

In an embodiment, the data pre-processing module (205) may process the received real-time operational data (203) using predefined processing logics. As an example, the data pre-processing module (205) may be configured to remove one or more anomalies from the real-time operational data (203). That is, the real-time operational data (203) may be analyzed for identifying any missing values in the measurements of parameters M1-M6 and S1 and remove any noise and outliers in the real-time operational data (203). In an embodiment, the data-pre-processing module may assign the missing values in the measurements of the parameters M1-M6 and S1 using known techniques for imputation. Similarly, the noise and outliers in the real-time operational data (203) may be removed using one of the known filtering techniques, selected based on the type of application. For example, the technique for imputation of the missing data may include, without limitation, moving averages filter technique. Similarly, the technique for filtering the noise and outliers may include, without limitation, the Fast Fourier Transformation (FFT). In an embodiment, the real-time operational data (203), which is corrected for all the missing values and free of noise and outliers may be used for further analysis by the prediction model (207).

In an embodiment, the prediction model (207) may comprise, without limitation, a primary prediction module (217a) and a plurality of secondary prediction modules (217b). In an embodiment, the primary prediction module (217a) and the plurality of secondary prediction modules (217b) may be Artificial Intelligence (AI) based models. As an example, the Al based models may be, without limitation, one or more unsupervised Machine Learning (ML) algorithms such as principal component analysis and deep neural network-based auto-encoder.

In an embodiment, the primary prediction module (217a) may be trained for detecting a system-level fault and/or a fault in the SHS (101) as a whole. That is, the primary prediction module (217a) detects a system fault in the SHS (101) by comparing the real-time operational data (203) of the SHS (101) with the optimal operational range of the SHS (101). The optimal operational range for the SHS (101) is determined during the training of the prediction model (207). In an embodiment, each of the plurality of secondary prediction modules (217b) may be trained for detecting a component-level fault and/or a fault in at least one of the plurality of components, upon determining a fault in the SHS (101). The plurality of secondary prediction modules (217b) may detect the component fault by comparing the real-time operational data (203) of each of the plurality of components with the optimal operational range of each of the plurality of components. Thus, in an embodiment, the primary prediction module (217a) and the plurality of secondary prediction modules (217b) may be operated in a hierarchical manner. That is, in the first phase of prediction, the real-time operational parameters of the SHS (101) may be monitored to identify the system fault in the SHS (101). The second phase of prediction may be initiated only upon confirming that a fault has occurred in the SHS (101). That is, the plurality of secondary prediction modules (217b)) monitors the real-time operational data (203) of each of the plurality of components to identify a root cause fault in one of the plurality of components, which has caused a fault in the SHS (101). Therefore, in an embodiment, when the SHS (101) is operating in the normal operating conditions (that is, without any faults), only the primary prediction module (217a) may be kept in an active state to constantly monitor and detect when a fault occurs in the SHS (101). The plurality of secondary prediction modules (217b) may be triggered only to track and identify the one or more components that have caused a fault in the SHS (101).

In an embodiment, the prediction model (207) may be further configured for forecasting the future operational state of each of the plurality of components. In an embodiment, the forecasting may be performed based on information related to the system fault detected in the SHS (101), information related to the component fault detected in at least one of the plurality of components and topology information related to the plurality of components, for performing the predictive maintenance of the SHS (101). The topology information related to the plurality of components represent the inter-dependency and/or operational dependency between the one or more components in the SHS (101). As an example, a process variation resulting in higher temperature of the flue gas may cause an increase in the temperature reading in the ring heater (i.e., ring heater temperature M1), the heat tracer line (heat tracer line temperature M2.) and the gas cooler (107) (cooler temperature M4). Thus, if the topology information is not considered for forecasting, these variations in the parameter values due to process change will result in false alarms and/or false predictions. For similar reasons, the prediction model (207) uses data from the upstream processes and downstream processes of the SHS (101) while forecasting the future operational state of each of the plurality of components. In an embodiment, the forecasted future operational state of the plurality of components helps in foreseeing a possible fault in the plurality of components, and thereby, performing required preventive operations to handle the fault in the plurality of components with minimum downtime or operational cost.

Figure. 3a illustrates a training phase of the prediction model (207) for determining optimal operational range for the SHS (101). As shown in Figure. 3a, the prediction model (207) takes in the real-time operational data (203) and the historical operational data (303) of the SHS (101) and the plurality of components in the SHS (101) for analysis. The real-time operational data (203) may be the time series data collected from the SHS (101), using various sensors including, without limitation, an acoustics sensor, a vibration sensor, a temperature sensor, a pressure sensor, a flow sensor, and a bypass valve (111) configured in the SHS (101). As an example, the real-time operational data (203) may be received at an interval of 5 minutes. In an embodiment, the historical operational data (303) may be the operational data collected over a predefined time period and stored in a database associated with the SHS (101). As an example, the historical operational data (303) may be the operational data collected for one year. In an embodiment, in case of unavailability of the historical operational data (303) with reported failures, the prediction model (207) may use one of the existing mathematical models for generating the required operational data with faults for training.

In an embodiment, the prediction model (207) may analyze the real-time operational data (203) and the historical operational data (303) for determining the optimal operational range for the SHS (101) (305a) and the optimal operational range for the plurality of components (305b). The optimal operational range of the SHS (101) and the plurality of components may be used during real-time monitoring of the SHS (101) for detecting whether there is a fault in the SHS (101) or at least one of the plurality of components.

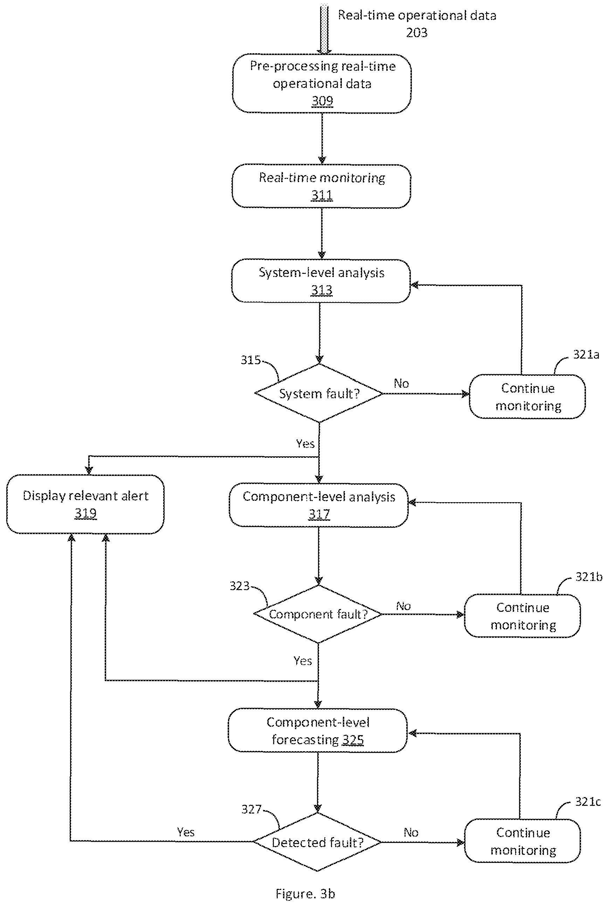

Figure. 3b illustrates an exemplary flowchart of real-time monitoring of the SHS (101) by the predictive maintenance system (201). In an embodiment, after receiving the real-time operational data (203) from the SHS (101) and the plurality of components, the prediction maintenance system, at step 309, may use the data pre-processing module (205) to perform one or more data pre-processing operations on the received real-time operational data (203) for preparing the real-time operational data (203) according to data format required by the prediction model (207). Further, at step 311, the predictive maintenance system (201) may use the prediction model (207) for real-time monitoring of the SHS (101) and the plurality of components in a hierarchical approach. Initially, at step 313, the prediction model (207) performs a system-level analysis by analyzing the processed real-time operational data (203) using the primary prediction module (217a) for detecting if there is a system fault in the SHS (101). If a system fault is detected, the prediction model (207) may display an appropriate fault notification or an alert on a User Interface associated with the predictive maintenance system (201), as indicated in steps 315 and 319. Alternatively, if no system fault is detected in the SHS (101), then the prediction model (207) may continue monitoring as shown in step 321a. Also, upon detecting a system fault in the SHS (101), the prediction model (207) may initiate a component-level analysis, as indicated in step 217.

During the component-level analysis, the prediction model (207) may analyze the processed real-time operational data (203) using the plurality of secondary prediction modules (217b) for detecting if there is a component fault in the SHS (101). If a component fault is detected in at least one of the plurality of components, then the prediction model (207) may display an appropriate fault notification or alert on the User Interface, as indicated in step 319. Alternatively, if no component fault is detected, then the prediction model (207) may continue with the monitoring as shown in step 321b. In an embodiment, after detecting a component fault in at least one of the plurality of components, the prediction model (207) may initiate forecasting of the future operational states of each of the plurality of components to predict and alert a possibility of future failures to an operator of the SHS (101).

Accordingly, at step 325, the prediction model (207) may initiate a component-level forecasting to forecast the future operational state of each of the plurality of components. Further, at step 327, if the prediction model (207) determines a possibility of fault in the plurality of components, then the prediction model (207) may display an appropriate fault notification or alert on the User Interface (step 319), so that the operator associated with the SHS (101) takes required preventive measures to avoid fault or failure in the SHS (101). Alternatively, if no fault is detected in the future operational state of the plurality of components, then the prediction model (207) may continue with the monitoring/forecasting as indicated in step 321c.

In an embodiment, while training the prediction model (207) for the component-level forecasting, the topology-based measurements may be used. For example, while training the prediction model (207) for the pump (109), the parameters M5, S1 and M6 may be considered along with the position of the bypass valve (111), M3 and gas analyzer flow. Similarly, while training the prediction model (207) for the gas cooler (107), the parameters M3, M4 and M5, along with M1, M2 and flue gas temperature from the upstream process may be utilized. Using such domain-based measurements for the training helps the prediction model (207) in learning faster with higher accuracy. This also prepares the prediction model (207) for learning complex interactions and dependencies among the plurality of components in the SHS (101).

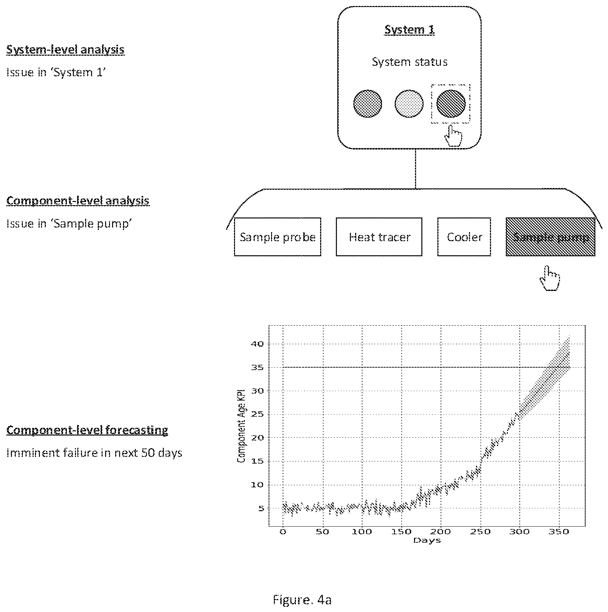

Figure. 4a illustrates an exemplary User Interface (UI) associated with the predictive maintenance system (201). In an embodiment, as part of information related to the system-level analysis, a current status of the system (i.e., the SHS (101)) may be indicated using a colored interface. If the current status of the system is 'normal', then 'Green' indicator may be highlighted in the interface. Similarly, if the forecast information indicates a possible system failure in the near future, then a 'Yellow' indicator may be highlighted in the interface. On the other hand, if the current status of the system is a 'faulty' state, then a 'Red' indicator may be highlighted in the interface. As an example, say, the current status of the system under consideration - 'System 1' is faulty, and accordingly 'Red' indicator is highlighted in the interface.

In an embodiment, since the fault has already occurred in the SHS (101), the prediction model (207) may initiate the component-level analysis to determine which one of the plurality of components in the SHS (101) has resulted in the fault. Accordingly, as part of information related to the component-level analysis, the faulty component may be highlighted in 'Red' in the UI. Thus, the UI makes it easier for an operator to understand the current status of the SHS (101) and each of the plurality of components in the SHS (101). Further, as part of information related to the component-level forecasting, one or more plots and graphs, indicating performance and timelines of a desired component, may be displayed on the UI. As an example, as shown in Figure. 4a, a plot indicating a threshold Key Performance Index (KPI) of a component and an indication of possible time taken by the component to reach the threshold KPI may be displayed on the UI. Such information may be used by the operators to plan the maintenance of the SHS (101) and/or the plurality of components in the SHS (101).

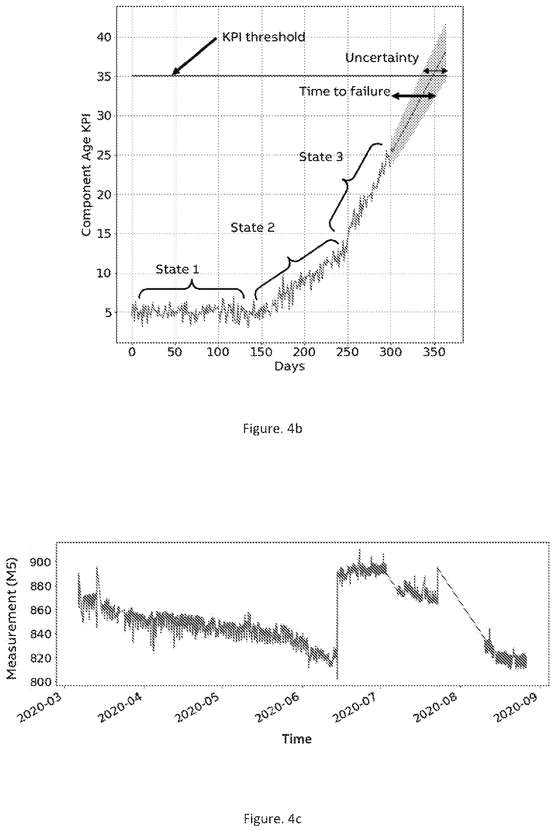

Figures. 4b and 4c show exemplary plots of the forecasted information. plotted using a representative data to explain the concept. Specifically, Figure 4b shows a plot of an ageing related KPI and its trend of a component. In an embodiment, the rate of degradation and/or ageing of the component may change over time. Such an exemplary degradation rate, which changes over time, is denoted in Figure. 4b at three different stages, namely 'State 1', 'State 2' and 'State 3'. 'State 1' represents an initial operating state of the component, at the early age of the component. 'State 2' represents a moderately aged operating state of the component, wherein the component has started to degrade. 'State 3' represents rapid degradation of the component. Beyond 'State 3', the component may cross its KPI threshold and may reach a state of failure or fault. The prediction model (207) may use this information related to the current health and/or degradation state of the component to forecast the time to failure of the component, which is represented as dashed blue line in Figure. 4b. Further, the highlighted region around the forecast may represent an uncertainty in the forecast.

In an embodiment, Figure 4c represents trend in cooler output pressure. As shown in the plot, there is a negative trend with changing slope. Suppose a pump maintenance activity has been reported in the first week of a previous month, which was preceded by few adjustments to the bypass valve to restore the analyzer flow. Here, though the cooler output pressure is not a direct degradation factor for the pump, a similar trend before the failure may be monitored and forecasted to estimate the time for failure. Accordingly, one of the existing forecasting algorithms such as Auto Regressive Moving Average (ARIMA) or Artificial Neural Network (ANN) based models such as Long and Short-Term Memory (LSTM) models may be used for forecasting the trends in the operational behavior of the component.

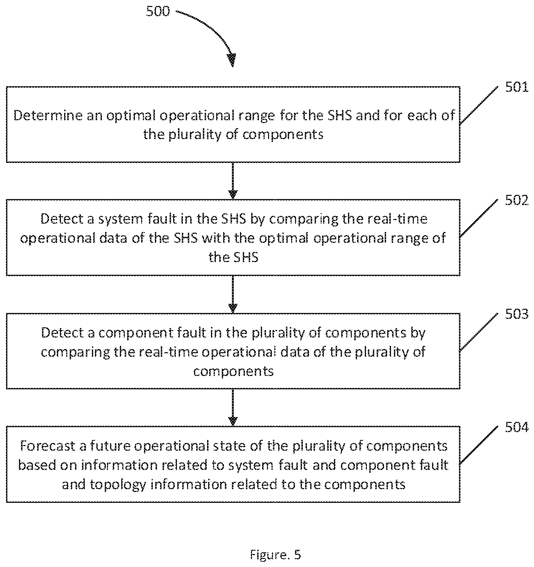

Figure. 5 illustrates a method of performing predictive maintenance of the SHS (101), in accordance with some embodiments of the present invention.

The method 500 illustrated in Figure 5, which is a collection of operations in a logical flow graph representing a sequence of operations, can be implemented in hardware, software, firmware, or a combination thereof. The order in which the method 500 is described is not intended to be construed as a limitation, and any number of the described method blocks can be combined in any order to implement the method, or alternate methods. Additionally, individual operations may be deleted from the method 500 without departing from the scope of the subject matter described herein. In the context of software, the operations represent computer instructions that, when executed by one or more processors (215), perform the recited operations. The various method steps in the method 500 are performed by a predictive maintenance system (201) for performing a predictive maintenance of a Sample Handling System, SHS (101) of a Gas Analyzer.

At step 501, the predictive maintenance system (201) determines an optimal operational range for the SHS (101) and for each of the plurality of components in the SHS (101), by analyzing the real-time operational data (203) and the historical operational data (303) related to the SHS (101) using a pretrained prediction model (207). In an embodiment, the pretrained prediction model (207) comprises a primary prediction module (217a) and a plurality of secondary prediction modules (217b). In an embodiment, the plurality of components of the SHS (101) may include, without limiting to, at least one of a sample probe (105), a gas cooler (107), a pump (109) a ring heater, a heat tracer line, and a filter, as shown in Figure. 1. In an embodiment, the prediction model (207) may determine the optimal operational range for the SHS (101) and each of the plurality of components by analyzing one or more domain specific logics and time series data related to one or more upstream processes and one or more downstream processes associated with the SHS (101).

At step 503, the predictive maintenance system (201) detects a system fault in the SHS (101) by comparing the real-time operational data (203) of the SHS (101) with the optimal operational range of the SHS (101) using a primary prediction module (217a) of the pretrained prediction model (207).

At step 505, the predictive maintenance system (201) detects a component fault in at least one of the plurality of components by comparing the real-time operational data (203) of each of the plurality of components with the optimal operational range of each of the plurality of components, using a plurality of secondary prediction modules (217b) of the pretrained prediction model (207). In an embodiment, the component fault in at least one of the plurality of components may be detected in the following steps. Initially, the plurality of secondary prediction modules (217b) may estimate a maximum number of degradation states for each of the plurality of components based on failure data associated with each of the plurality of components. Further, the plurality of secondary prediction modules (217b) may detect a current degradation state of each of the plurality of components by correlating the maximum number of degradation states of each of the plurality of components with the real-time operational data (203) associated with each of the plurality of components.

At step 507, the predictive maintenance system (201) forecasts a future operational state of each of the plurality of components. The forecasting may be performed based on information related to the system fault, information related to the component fault and topology information related to the plurality of components. In an embodiment, the predictive maintenance system (201) may display information related to the future operational state on a user interface associated with the predictive maintenance system (201), after forecasting the future operational state of the plurality of components. In addition, the predictive maintenance system (201) may be configured for generating one or more alerts upon identifying the fault in the future operational state. Also, the predictive maintenance system (201) may be configured for generating a fault propagation path, corresponding to the fault in the future operational state, using the topology information related to the plurality of components.

This written description uses examples to describe the subject matter herein, including the best mode, and also to enable any person skilled in the art to make and use the subject matter. The patentable scope of the subject matter is defined by the claims, and may include other examples that occur to those skilled in the art. Such other examples are intended to be within the scope of the claims if they have structural elements that do not differ from the literal language of the claims.

### Referral Numerals:

101 - Sample Handling System (SHS)
103 - Flue gas stack
105 - Sample probe
107 - Gas cooler
109 - Pump
111 - Bypass valve
113 - Gas analyzer
115 - Analyzed gas
201 - Predictive maintenance system
203 - Real-time operational data
205 - Data pre-processing module
207 - Prediction model
209 - Forecasted output
211 - Memory
213 - I/O Interface
215 - Processor
217a - Primary prediction module
217b - Secondary prediction modules
303 - Historical operational data
305a - Optimal operational range for SHS
305b - Optimal operational range for components

## Claims

1. A method for performing a predictive maintenance of a Sample Handling System, SHS, (101) of a Gas Analyzer, by a predictive maintenance system (201) operationally coupled with the SHS (101), wherein the SHS (101) comprises a plurality of components and is associated with at least one database, wherein the at least one database is configured to store at least one of real-time operational data (203) and historical operational data (303) related to the SHS (101) and each of the plurality components in the SHS (101), the method comprising:
determining an optimal operational range for the SHS (101) and for each of the plurality of components, by analyzing the real-time operational data (203) and the historical operational data (303) using a pretrained prediction model (207), wherein the pretrained prediction model (207) comprises a primary prediction module (217a) and a plurality of secondary prediction modules (217b);
detecting a system fault in the SHS (101) by comparing the real-time operational data (203) of the SHS (101) with the optimal operational range of the SHS (101) using the primary prediction module (217a);
detecting, upon detecting the system fault in the current operational state of the SHS (101), a component fault in at least one of the plurality of components by comparing the real-time operational data (203) of each of the plurality of components with the optimal operational range of each of the plurality of components using the plurality of secondary prediction modules (217b); and
forecasting a future operational state of each of the plurality of components based on information related to the system fault detected in the SHS (101), information related to the component fault detected in at least one of the plurality of components and topology information related to the plurality of components, for performing the predictive maintenance of the SHS (101).

2. The method as claimed in the preceding claim, wherein the plurality of components of the SHS (101) comprises at least one of a sample probe (105), a gas cooler (107), a pump (109), a bypass valve (111), a ring heater, a heat tracer line and a filter.

3. The method as claimed in any one of the preceding claims, wherein determining the optimal operational range for the SHS (101) and each of the plurality of components further comprises analyzing, by the pretrained prediction model (207), one or more domain specific logics and time series data related to one or more upstream processes and one or more downstream processes associated with the SHS (101).

4. The method as claimed in any one of the preceding claims, wherein detecting the component fault in at least one of the plurality of components further comprises:
estimating, using the plurality of secondary prediction modules (217b), a maximum number of degradation states for each of the plurality of components based on failure data associated with each of the plurality of components; and
detecting, using the plurality of secondary prediction modules (217b), a current degradation state of each of the plurality of components by correlating the maximum number of degradation states of each of the plurality of components with the real-time operational data (203) associated with each of the plurality of components.

5. The method as claimed in any one of the preceding claims, wherein forecasting the future operational state of each of the plurality of components comprises displaying information related to the future operational state on a user interface associated with the predictive maintenance system (201).

6. The method as claimed in any one of the preceding claims, further comprises:
comparing the future operational state of each of the plurality of components with a threshold operational range;
identifying a fault in the future operational state of the plurality of components based on comparison; and
generating one or more alerts upon identifying the fault in the future operational state.

7. The method as claimed in the preceding claim further comprises generating a fault propagation path, corresponding to the fault in the future operational state, using the topology information related to the plurality of components.

8. The method as claimed in any one of the preceding claims further comprises optionally configuring the predictive maintenance system (201) on at least one of an edge device or a cloud platform for remotely performing the predictive maintenance of the SHS (101).

9. A predictive maintenance system (201) for performing a predictive maintenance of a Sample Handling System, SHS, (101) of a Gas Analyzer, wherein the predictive maintenance system (201) is operationally coupled with the SHS (101), wherein the SHS (101) comprises a plurality of components and is associated with at least one database, wherein the at least one database is configured to store at least one of real-time operational data (203) and historical operational data (303) related to the SHS (101) and each of the plurality components in the SHS (101), the predictive maintenance system (201) comprising:
a memory (211); and
one or more processors (215) configured to:
determine an optimal operational range for the SHS (101) and for each of the plurality of components, by analyzing the real-time operational data (203) and the historical operational data (303) using a pretrained prediction model (207), wherein the pretrained prediction model (207) comprises a primary prediction module (217a) and a plurality of secondary prediction modules (217b);
detect a system fault in the SHS (101) by comparing the real-time operational data (203) of the SHS (101) with the optimal operational range of the SHS (101) using the primary prediction module (217a);
detect, upon detecting the system fault in the current operational state of the SHS (101), a component fault in at least one of the plurality of components by comparing the real-time operational data (203) of each of the plurality of components with the optimal operational range of each of the plurality of components using the plurality of secondary prediction modules (217b); and
forecast a future operational state of each of the plurality of components based on information related to the system fault detected in the SHS (101), information related to the component fault detected in at least one of the plurality of components and topology information related to the plurality of components, for performing the predictive maintenance of the SHS (101).

10. The predictive maintenance system (201) as claimed in the preceding claim, wherein the one or more processors (215) determine the optimal operational range for the SHS (101) and each of the plurality of components by analyzing, using the pretrained prediction model (207), one or more domain specific logics and time series data related to one or more upstream processes and one or more downstream processes associated with the SHS (101).

11. The predictive maintenance system (201) as claimed in claim 9 or 10, wherein the one or more processors (215) detect the component fault in at least one of the plurality of components by:
estimating, using the plurality of secondary prediction modules (217b), a maximum number of degradation states for each of the plurality of components based on failure data associated with each of the plurality of components; and
detecting, using the plurality of secondary prediction modules (217b), a current degradation state of each of the plurality of components by correlating the maximum number of degradation states of each of the plurality of components with the real-time operational data (203) associated with each of the plurality of components.

12. The predictive maintenance system (201) as claimed in any one of claims 9 to 11, wherein the one or more processors (215) are further configured to display information related to the future operational state on a user interface associated with the predictive maintenance system (201) after forecasting the future operational state of each of the plurality of components.

13. The predictive maintenance system (201) as claimed in any one of claims 9 to 12, wherein the one or more processors (215) are further configured to:
compare the future operational state of each of the plurality of components with a threshold operational range;
identify a fault in the future operational state of the plurality of components based on comparison; and
generate one or more alerts upon identifying the fault in the future operational state.

14. The predictive maintenance system (201) as claimed in the preceding claim, wherein the one or more processors (215) are further configured to generate a fault propagation path, corresponding to the fault in the future operational state, using the topology information related to the plurality of components.

15. The predictive maintenance system (201) as claimed in any one of claims 9 to 14, wherein the predictive maintenance system (201) is optionally configured on at least one of an edge device or a cloud platform for remotely performing the predictive maintenance of the SHS (101).

## Patentansprüche

1. Verfahren zum Durchführen einer prädiktiven Wartung eines Probenhandhabungssystems, SHS, (101) eines Gasanalysators durch ein System zur prädiktiven Wartung (201), das betriebsmäßig mit dem SHS (101) gekoppelt ist, wobei das SHS (101) eine Vielzahl von Komponenten umfasst und mit mindestens einer Datenbank assoziiert ist, wobei die mindestens eine Datenbank dazu ausgelegt ist, mindestens eines von Echtzeitbetriebsdaten (203) und historischen Betriebsdaten (303) in Bezug auf das SHS (101) und jede der Vielzahl von Komponenten in dem SHS (101) zu speichern, wobei das Verfahren umfasst:
Bestimmen eines optimalen Betriebsbereichs für das SHS (101) und für jede der Vielzahl von Komponenten durch Analysieren der Echtzeitbetriebsdaten (203) und der historischen Betriebsdaten (303) unter Verwendung eines vortrainierten Vorhersagemodells (207), wobei das vortrainierte Vorhersagemodell (207) ein primäres Vorhersagemodul (217a) und eine Vielzahl sekundärer Vorhersagemodule (217b) umfasst;
Detektieren eines Systemfehlers in dem SHS (101) durch Vergleichen der Echtzeitbetriebsdaten (203) des SHS (101) mit dem optimalen Betriebsbereich des SHS (101) unter Verwendung des primären Vorhersagemoduls (217a);
Detektieren, beim Detektieren des Systemfehlers im aktuellen Betriebszustand des SHS (101), eines Komponentenfehlers in mindestens einer der Vielzahl von Komponenten durch Vergleichen der Echtzeitbetriebsdaten (203) jeder der Vielzahl von Komponenten mit dem optimalen Betriebsbereich jeder der Vielzahl von Komponenten unter Verwendung der Vielzahl sekundärer Vorhersagemodule (217b); und
Vorhersagen eines zukünftigen Betriebszustands jeder der Vielzahl von Komponenten basierend auf Informationen in Bezug auf den im SHS (101) detektierten Systemfehler, Informationen in Bezug auf den in mindestens einer der Vielzahl von Komponenten detektierten Komponentenfehler und Topologieinformationen in Bezug auf die Vielzahl von Komponenten zum Durchführen der prädiktiven Wartung des SHS (101).

2. Verfahren nach dem vorhergehenden Anspruch, wobei die Vielzahl von Komponenten des SHS (101) mindestens eines von einer Probensonde (105), einem Gaskühler (107), einer Pumpe (109), einem Bypassventil (111), einer Ringheizung, einer Wärmespürgerätleitung und einem Filter umfassen.

3. Verfahren nach einem der vorhergehenden Ansprüche, wobei das Bestimmen des optimalen Betriebsbereichs für das SHS (101) und jede der Vielzahl von Komponenten ferner ein Analysieren, durch das vortrainierte Vorhersagemodell (207), einer domänenspezifischen Logik und eines Zeitreihendatenelements oder mehrerer domänenspezifischer Logiken und Zeitreihendaten in Bezug auf einen oder mehrere Upstream-Prozess(e) und einen oder mehrere Downstream-Prozess(e), die mit dem SHS (101) assoziiert sind, umfasst.

4. Verfahren nach einem der vorhergehenden Ansprüche, wobei das Detektieren des Komponentenfehlers in mindestens einer der Vielzahl von Komponenten ferner umfasst:
Schätzen, unter Verwendung der Vielzahl sekundärer Vorhersagemodule (217b), einer maximalen Anzahl von Verschlechterungszuständen für jede der Vielzahl von Komponenten basierend auf Fehlerdaten, die mit jeder der Vielzahl von Komponenten assoziiert sind; und
Detektieren, unter Verwendung der Vielzahl sekundärer Vorhersagemodule (217b), eines aktuellen Verschlechterungszustands jeder der Vielzahl von Komponenten durch Korrelieren der maximalen Anzahl von Verschlechterungszuständen jeder der Vielzahl von Komponenten mit den Echtzeitbetriebsdaten (203), die mit jeder der Vielzahl von Komponenten assoziiert sind.

5. Verfahren nach einem der vorhergehenden Ansprüche, wobei das Vorhersagen des zukünftigen Betriebszustands jeder der Vielzahl von Komponenten ein Anzeigen von Informationen in Bezug auf den zukünftigen Betriebszustand auf einer Benutzerschnittstelle, die mit dem System zur prädiktiven Wartung (201) assoziiert ist, umfasst.

6. Verfahren nach einem der vorhergehenden Ansprüche, das ferner umfasst:
Vergleichen des zukünftigen Betriebszustands jeder der Vielzahl von Komponenten mit einem Schwellenbetriebsbereich;
Identifizieren eines Fehlers im zukünftigen Betriebszustand der Vielzahl von Komponenten basierend auf einem Vergleich; und
Erzeugen einer oder mehrerer Warnung(en) beim Identifizieren des Fehlers im zukünftigen Betriebszustand.

7. Verfahren nach dem vorhergehenden Anspruch, das ferner ein Erzeugen eines Fehlerausbreitungspfads, der dem Fehler im zukünftigen Betriebszustand entspricht, unter Verwendung der Topologieinformationen in Bezug auf die Vielzahl von Komponenten umfasst.

8. Verfahren nach einem der vorhergehenden Ansprüche, das ferner ein optionales Konfigurieren des Systems zur prädiktiven Wartung (201) auf mindestens einem von einer Edge-Vorrichtung oder einer Cloud-Plattform zum entfernten Durchführen der prädiktiven Wartung des SHS (101) umfasst.

9. System zur prädiktiven Wartung (201) zum Durchführen einer prädiktiven Wartung eines Probenhandhabungssystems, SHS, (101) eines Gasanalysators, wobei das System zur prädiktiven Wartung (201) betriebsmäßig mit dem SHS (101) gekoppelt ist, wobei das SHS (101) eine Vielzahl von Komponenten umfasst und mit mindestens einer Datenbank assoziiert ist, wobei die mindestens eine Datenbank dazu ausgelegt ist, mindestens eines von Echtzeitbetriebsdaten (203) und historischen Betriebsdaten (303) in Bezug auf das SHS (101) und jede der Vielzahl von Komponenten in dem SHS (101) zu speichern, wobei das System zur prädiktiven Wartung (201) umfasst:
einen Speicher (211) und
einen oder mehrere Prozessor(en) (215), der/die ausgelegt ist/sind zum:
Bestimmen eines optimalen Betriebsbereichs für das SHS (101) und für jede der Vielzahl von Komponenten durch Analysieren der Echtzeitbetriebsdaten (203) und der historischen Betriebsdaten (303) unter Verwendung eines vortrainierten Vorhersagemodells (207), wobei das vortrainierte Vorhersagemodell (207) ein primäres Vorhersagemodul (217a) und eine Vielzahl sekundärer Vorhersagemodule (217b) umfasst;
Detektieren eines Systemfehlers in dem SHS (101) durch Vergleichen der Echtzeitbetriebsdaten (203) des SHS (101) mit dem optimalen Betriebsbereich des SHS (101) unter Verwendung des primären Vorhersagemoduls (217a);
Detektieren, beim Detektieren des Systemfehlers im aktuellen Betriebszustand des SHS (101), eines Komponentenfehlers in mindestens einer der Vielzahl von Komponenten durch Vergleichen der Echtzeitbetriebsdaten (203) jeder der Vielzahl von Komponenten mit dem optimalen Betriebsbereich jeder der Vielzahl von Komponenten unter Verwendung der Vielzahl sekundärer Vorhersagemodule (217b); und
Vorhersagen eines zukünftigen Betriebszustands jeder der Vielzahl von Komponenten basierend auf Informationen in Bezug auf den im SHS (101) detektierten Systemfehler, Informationen in Bezug auf den in mindestens einer der Vielzahl von Komponenten detektierten Komponentenfehler und Topologieinformationen in Bezug auf die Vielzahl von Komponenten zum Durchführen der prädiktiven Wartung des SHS (101).

10. System zur prädiktiven Wartung (201) nach dem vorhergehenden Anspruch, wobei der eine oder die mehreren Prozessor(en) (215) den optimalen Betriebsbereich für das SHS (101) und jede der Vielzahl von Komponenten durch Analysieren, unter Verwendung des vortrainierten Vorhersagemodells (207), einer domänenspezifischen Logik und eines Zeitreihendatenelements oder mehrerer domänenspezifischer Logiken und Zeitreihendaten in Bezug auf einen oder mehrere Upstream-Prozess(e) und einen oder mehrere Downstream-Prozess(e), die mit dem SHS (101) assoziiert sind, bestimmt/bestimmen.

11. System zur prädiktiven Wartung (201) nach Anspruch 9 oder 10, wobei der eine oder die mehreren Prozessor(en) (215) den Komponentenfehler in mindestens einer der Vielzahl von Komponenten detektiert/detektieren durch:
Schätzen, unter Verwendung der Vielzahl sekundärer Vorhersagemodule (217b), einer maximalen Anzahl von Verschlechterungszuständen für jede der Vielzahl von Komponenten basierend auf Fehlerdaten, die mit jeder der Vielzahl von Komponenten assoziiert sind; und
Detektieren, unter Verwendung der Vielzahl sekundärer Vorhersagemodule (217b), eines aktuellen Verschlechterungszustands jeder der Vielzahl von Komponenten durch Korrelieren der maximalen Anzahl von Verschlechterungszuständen jeder der Vielzahl von Komponenten mit den Echtzeitbetriebsdaten (203), die mit jeder der Vielzahl von Komponenten assoziiert sind.

12. System zur prädiktiven Wartung (201) nach einem der Ansprüche 9 bis 11, wobei der eine oder die mehreren Prozessor(en) (215) ferner dazu ausgelegt ist/sind, Informationen in Bezug auf den zukünftigen Betriebszustand auf einer Benutzerschnittstelle, die mit dem System zur prädiktiven Wartung (201) assoziiert ist, nach dem Vorhersagen des zukünftigen Betriebszustands jeder der Vielzahl von Komponenten anzuzeigen.

13. System zur prädiktiven Wartung (201) nach einem der Ansprüche 9 bis 12, wobei der eine oder die mehreren Prozessor(en) (215) ferner ausgelegt ist/sind zum:
Vergleichen des zukünftigen Betriebszustands jeder der Vielzahl von Komponenten mit einem Schwellenbetriebsbereich;
Identifizieren eines Fehlers im zukünftigen Betriebszustand der Vielzahl von Komponenten basierend auf einem Vergleich; und
Erzeugen einer oder mehrerer Warnung(en) beim Identifizieren des Fehlers im zukünftigen Betriebszustand.

14. System zur prädiktiven Wartung (201) nach dem vorhergehenden Anspruch, wobei der eine oder die mehreren Prozessor(en) (215) ferner dazu ausgelegt ist/sind, einen Fehlerausbreitungspfad, der dem Fehler im zukünftigen Betriebszustand entspricht, unter Verwendung der Topologieinformationen in Bezug auf die Vielzahl von Komponenten zu erzeugen.

15. System zur prädiktiven Wartung (201) nach einem der Ansprüche 9 bis 14, wobei das System zur prädiktiven Wartung (201) optional auf mindestens einem von einer Edge-Vorrichtung oder einer Cloud-Plattform zum entfernten Durchführen der prädiktiven Wartung des SHS (101) konfiguriert ist.

## Revendications

1. Procédé pour effectuer une maintenance prédictive d'un système de manipulation d'échantillons, SHS, (101) d'un analyseur de gaz, par un système de maintenance prédictive (201) couplé de manière fonctionnelle au SHS (101), où le SHS (101) comprend une pluralité de composants et est associé à au moins une base de données, l'au moins une base de données étant configurée pour stocker au moins une donnée parmi des données opérationnelles en temps réel (203) et des données historiques opérationnelles (303) liées au SHS (101) et chacun de la pluralité de composants dans le SHS (101), le procédé comprenant les étapes suivantes :
déterminer une plage opérationnelle optimale pour le SHS (101) et pour chacun de la pluralité de composants, par analyse des données opérationnelles en temps réel (203) et des données opérationnelles historiques (303) en utilisant un modèle de prédiction pré-entrainé (207), où le modèle de prédiction pré-entrainé (207) comprend un module de prédiction primaire (217a) et une pluralité de modules de prédiction secondaires (217b) ;
détecter un défaut système du SHS (101) en comparant les données opérationnelles en temps réel (203) du SHS (101) à la plage opérationnelle optimale du SHS (101) à l'aide du module de prédiction primaire (217a) ;
détecter, lors de la détection de la défaillance système dans l'état opérationnel courant du SHS (101), une défaillance de composant dans au moins un de la pluralité de composants par comparaison des données opérationnelles en temps réel (203) de chacun de la pluralité de composants avec la plage opérationnelle optimale de chacun de la pluralité de composants à l'aide de la pluralité de modules de prédiction secondaires (217b) ; et
prévoir un état de fonctionnement futur de chacun de la pluralité de composants sur la base d'informations relatives à la défaillance du système détectée dans le SHS (101), d'informations relatives à la défaillance du composant détectée dans au moins un des composants et d'informations de topologie relatives à la pluralité des composants, pour effectuer la maintenance prédictive du SHS (101).

2. Procédé selon la revendication précédente, dans lequel la pluralité de composants du SHS (101) comprend au moins un élément parmi une sonde d'échantillon (105), un refroidisseur de gaz (107), une pompe (109), une vanne de dérivation (111), un réchauffeur d'anneau, une ligne de traceur de chaleur et un filtre.

3. Procédé selon l'une quelconque des revendications précédentes, dans lequel la détermination de la plage opérationnelle optimale pour le SHS (101) et de chacun de la pluralité de composants comprend en outre l'analyse, par le modèle de prédiction pré-entraîné (207), d'une ou plusieurs logiques spécifiques au domaine et de données chronologiques liées à un ou plusieurs processus en amont et à un ou plusieurs processus en aval associés au SHS (101).

4. Procédé selon l'une quelconque des revendications précédentes, dans lequel la détection de la défaillance d'un composant dans au moins un de la pluralité de composants comprend en outre les étapes suivantes :
estimer, à l'aide de la pluralité de modules de prédiction secondaires (217b), un nombre maximum d'états de dégradation pour chacun de la pluralité de composants sur la base de données de défaillance associées à chacun de la pluralité de composants ; et
détecter, à l'aide de la pluralité de modules de prédiction secondaires (217b), un état de dégradation courant de chacun de la pluralité de composants par corrélation du nombre maximum d'états de dégradation de chacun de la pluralité de composants avec les données opérationnelles en temps réel (203) associées à chacun de la pluralité de composants.

5. Procédé selon l'une quelconque des revendications précédentes, dans lequel la prévision de l'état opérationnel futur de chacun de la pluralité de composants comprend l'affichage d'informations relatives à l'état opérationnel futur sur une interface utilisateur associée au système de maintenance prédictive (201).

6. Procédé selon l'une quelconque des revendications précédentes, comprenant en outre les étapes suivantes :
comparer l'état opérationnel futur de chacun de la pluralité de composants à une plage opérationnelle seuil ;
identifier une défaillance de l'état opérationnel futur de la pluralité de composants sur la base d'une comparaison ; et
générer une ou plusieurs alertes lors de l'identification de la défaillance dans l'état opérationnel futur.

7. Procédé selon la revendication précédente, comprenant en outre de générer un chemin de propagation de défaillance, correspondant à la défaillance dans l'état opérationnel futur, en utilisant les informations de topologie relatives à la pluralité de composants.

8. Procédé selon l'une quelconque des revendications précédentes comprenant en outre éventuellement de configurer le système de maintenance prédictive (201) sur au moins l'un d'un dispositif périphérique ou d'une plateforme cloud pour effectuer à distance la maintenance prédictive du SHS (101).

9. Système de maintenance prédictive (201) pour effectuer une maintenance prédictive d'un système de manipulation d'échantillons, SHS, (101) d'un analyseur de gaz, où le système de maintenance prédictive (201) est couplé de manière fonctionnelle au SHS (101), où le SHS (101) comprend une pluralité de composants et est associé à au moins une base de données, l'au moins une base de données étant configurée pour stocker au moins une donnée parmi des données opérationnelles en temps réel (203) et des données historiques opérationnelles (303) liées au SHS (101) et chacun de la pluralité de composants dans le SHS (101), le système de maintenance prédictive (201) comprenant :
une mémoire (211) ; et
un ou plusieurs processeurs (215) configurés pour :
déterminer une plage opérationnelle optimale pour le SHS (101) et pour chacun de la pluralité de composants, par analyse des données opérationnelles en temps réel (203) et des données opérationnelles historiques (303) en utilisant un modèle de prédiction pré-entrainé (207), où le modèle de prédiction pré-entrainé (207) comprend un module de prédiction primaire (217a) et une pluralité de modules de prédiction secondaires (217b) ;
détecter un défaut système du SHS (101) en comparant les données opérationnelles en temps réel (203) du SHS (101) à la plage opérationnelle optimale du SHS (101) à l'aide du module de prédiction primaire (217a) ;
détecter, lors de la détection de la panne système dans l'état opérationnel courant du SHS (101), une panne de composant dans au moins un de la pluralité de composants par comparaison des données opérationnelles en temps réel (203) de chacun de la pluralité de composants avec la plage opérationnelle optimale de chacun de la pluralité de composants à l'aide de la pluralité de modules de prédiction secondaires (217b) ; et
prévoir un état de fonctionnement futur de chacun de la pluralité de composants sur la base d'informations relatives à la défaillance du système détectée dans le SHS (101), d'informations relatives à la défaillance du composant détectée dans au moins un des composants et d'informations de topologie relatives à la pluralité des composants, pour effectuer la maintenance prédictive du SHS (101).

10. Système de maintenance prédictive (201) selon la revendication précédente, dans lequel les un ou plusieurs processeurs (215) déterminent la plage opérationnelle optimale pour le SHS (101) et chacun de la pluralité de composants en analysant, à l'aide du modèle de prédiction pré-entrainé (207), une ou plusieurs logiques spécifiques au domaine et des données chronologiques liées à un ou plusieurs processus en amont et un ou plusieurs processus en aval associés au SHS (101).

11. Système (201) de maintenance prédictive selon la revendication 9 ou la revendication 10, dans lequel les un ou plusieurs processeurs (215) détectent la défaillance d'un composant dans au moins un de la pluralité de composants en :
estimer, à l'aide de la pluralité de modules de prédiction secondaires (217b), un nombre maximum d'états de dégradation pour chacun de la pluralité de composants sur la base de données de défaillance associées à chacun de la pluralité de composants ; et
détecter, à l'aide de la pluralité de modules de prédiction secondaires (217b), un état de dégradation courant de chacun de la pluralité de composants par corrélation du nombre maximum d'états de dégradation de chacun de la pluralité de composants avec les données opérationnelles en temps réel (203) associées à chacun de la pluralité de composants.

12. Système de maintenance prédictive (201) selon l'une quelconque des revendications 9 à 11, dans lequel les un ou plusieurs processeurs (215) sont en outre configurés pour afficher des informations relatives à l'état opérationnel futur sur une interface utilisateur associée au système de maintenance prédictive (201) après prévision de l'état opérationnel futur de chacun de la pluralité de composants.

13. Système (201) de maintenance prédictive selon l'une quelconque des revendications 9 à 12, dans lequel les un ou plusieurs processeurs (215) sont en outre configurés pour :
comparer l'état opérationnel futur de chacun de la pluralité de composants à une plage opérationnelle seuil ;
identifier une défaillance de l'état opérationnel futur de la pluralité de composants sur la base d'une comparaison ; et
générer une ou plusieurs alertes lors de l'identification de la défaillance dans l'état opérationnel futur.

14. Système de maintenance prédictive (201) selon la revendication précédente, dans lequel les un ou plusieurs processeurs (215) sont en outre configurés pour générer un chemin de propagation de défaillance, correspondant à la défaillance dans l'état opérationnel futur, en utilisant les informations de topologie liées à la pluralité de composants.

15. Système de maintenance prédictive (201) selon l'une quelconque des revendications 9 à 14, dans lequel le système de maintenance prédictive (201) est éventuellement configuré sur au moins l'un d'un équipement périphérique ou d'une plateforme cloud pour effectuer à distance la maintenance prédictive du SHS (101).
